# EUROPEAN PATENT APPLICATION

(11) **EP 1 802 181 A1**
(43) Date of publication of application: **27.06.2007**
(21) Application number: 06123433.2
(22) Date of filing: 03.11.2006
(51) Int. Cl.: H05K 1/11, H05K 3/42

(54) **Via structure of a printed circuit board**

(30) Priority: 26.12.2005 CN 200510003593
(71) Applicant: High Tech Computer Corp., Taoyuan City, Taoyuan Hsien (TW)
(72) Inventor: Ho, Chin-Wei, Taoyuan Hsien Taoyuan City (TW)
(74) Representative: Schwabe - Sandmair - Marx

(57) **Abstract**

A via structure of a printed circuit board includes an insulation layer having a first surface and a second surface, a through-hole and a plurality of internal conducting coatings. The through-hole is throughout the first surface and the second surface of the insulation layer and the internal conductive coatings connected to a wall of the through-hole are mutually electrically insulated so that different signals can be transmitted between both sides of the substrate through a single via.

## Description

### BACKGROUND

### Field of Invention

The present invention relates to a via structure. More particularly, the present invention relates to a via structure of a printed circuit board capable of multiple signal transmission.

### Description of Related Art

As electronic technology improves, electronic products include more and more functions, improve their performance, and become lighter weight and smaller in scale. In developing products with more functionality, circuit layout becomes more complicated inevitably, making device allocation in the limited space of a printed circuit board (PCB) a considerable issue. With the conventional via structure, the objective of lighter weight and smaller scale is hard to achieve.

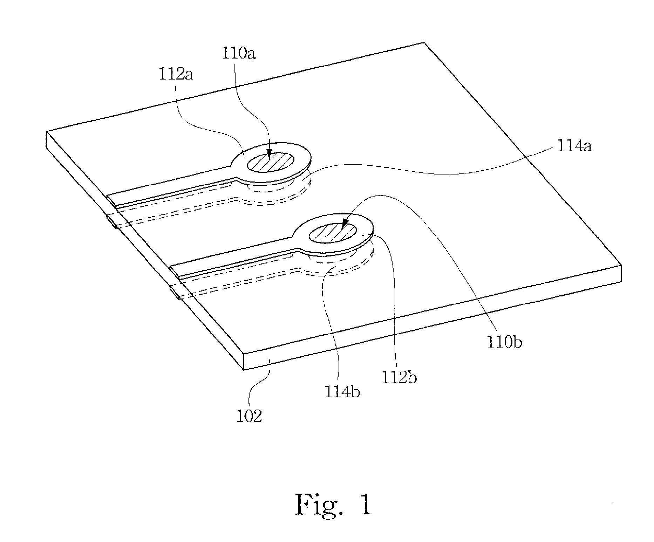

Fig. 1 shows a schematic view of a conventional via structure. For most conventional PCBs, a via structure is designed to transmit only one signal. The via is a structure with a through-hole 110a or 110b whose top side and bottom side are electrically connected and the structure is formed by electroplating a conductive material like copper in the through-hole 110a or 110b through the depth of a layer, typically an insulation layer 102. The figure shows that in a conventional printed circuit board, a proper layer-to-layer transmission for each of two different signals requires two individual vias along with corresponding upper pads 112a and 112b, and corresponding lower pads 114a and 114b.

Such a via design occupies too much circuit board area and hence limits the future PCB designs featuring finer layouts and also wastes circuit board material.

For the foregoing reasons, there is a need for an improved PCB design that eliminates the limitation above and allows circuit board space to be used more efficiently.

### SUMMARY

It is therefore an objective of the present invention to provide a via structure of a printed circuit board for reducing required layout area to efficiently utilize space of a circuit board.

It is another aspect of the present invention to provide a via structure of a printed circuit board for reducing circuit board volume and cost thereof as well as for reducing manufacturing time.

In accordance with the foregoing and other objectives of the present invention, a via structure of a printed circuit board is provided which includes an insulation layer having a first surface and a second surface, a through-hole and a plurality of internal conducting coatings. The through-hole is disposed in the insulation layer and opens at both of the first surface and the second surface. The internal conducting coatings are connected to a wall of the through-hole and separated physically and electrically from each other.

According to a preferred embodiment, the insulation layer is a part of a substrate. The substrate is a copper-clad laminate which consists of the insulation layer and two conduction layers respectively bonded to a top side and bottom side of the insulation layer. The internal conducting coatings are formed in the through-hole and connected to the wall of the through-hole. The through-hole includes a plurality of internal hole gaps separating the internal conducting coatings; therefore the internal conducting coatings are electrically insulated from each other.

The internal conducting coatings individually correspond and electrically connect to a plurality of upper pads and to a plurality of lower pads, each kind of pad also separated physically and electrically.

Each of different signals is transmitted via a set of corresponding upper pad, internal conducting coating and lower pad so that multiple signal transmissions between layers can be fulfilled by only one hole area.

In conclusion, a via with several isolated internal conducting coatings, each of which serves as a specific transmitting path, allows itself to transmit multiple signals between layers simultaneously. Therefore, a problem of requiring a large circuit board area on the basis of the conventional technology requiring a single through-hole to be responsible for only one signal transmission is solved, thereby aiding future circuit layout advances. The present invention further lowers required circuit board volume and hence cost.

It is to be understood that both the foregoing general description and the following detailed description are by examples and are intended to provide further explanation of the invention as claimed.

### BRIEF DESCRIPTION OF THE DRAWINGS

These and other features, aspects and advantages of the present invention are better understood with regard to the following description, appended claims and accompanying drawings, wherein:
Fig. 1 is a schematic view of a conventional via structure;
Fig. 2A is a schematic view of a via structure of a printed circuit board in accordance with a preferred embodiment of the present invention;
Fig. 2B is a top view of the via structure of the printed circuit board in Fig. 2A;
Fig. 2C is a schematic view of an internal hole gap in accordance with a preferred embodiment of the present invention;
Fig. 3A is a schematic view of a via structure of a printed circuit board in accordance with another preferred embodiment of the present invention; and
Fig. 3B is a top view of the via structure of the printed circuit board in Fig. 3A.

### DESCRIPTION OF THE PREFERRED EMBODIMENTS

The present invention discloses a via structure of a printed circuit board capable of transmitting multiple signals simultaneously. By dividing a via into several independent segments, multiple signals can be transmitted with the equivalent of one via area. Reference is now made in detail to the present preferred embodiments of the invention, examples of which are illustrated in the accompanying drawings. Wherever possible, the same reference numbers are used in the drawings and the description to refer to the same or like parts.

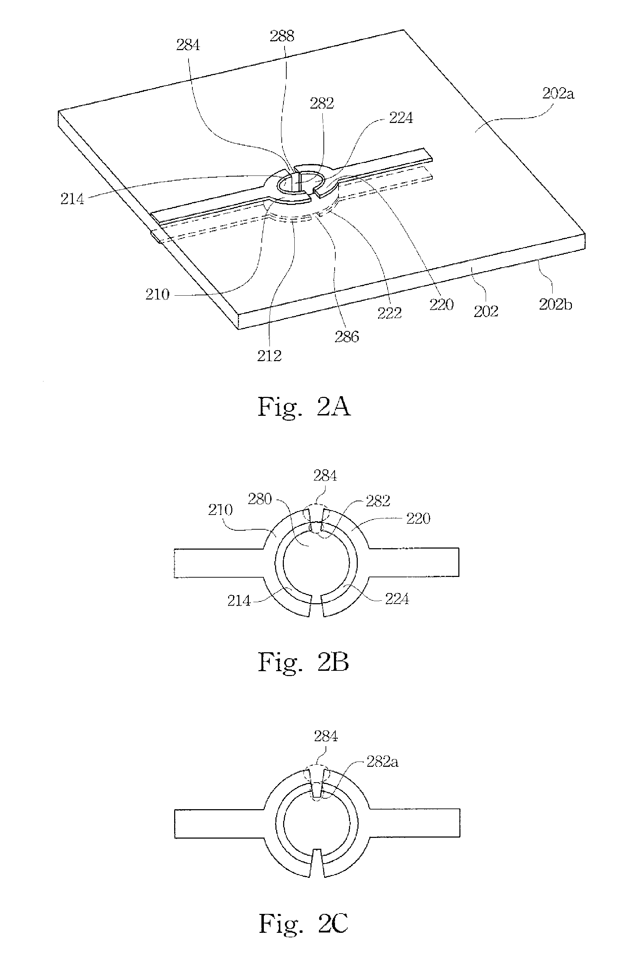

Figs. 2A and 2B respectively illustrate a schematic view and a top view of a via structure of a printed circuit board in accordance with a preferred embodiment of the present invention. The via structure of the printed circuit board includes an insulation layer having a first surface 202a and a second surface 202b, a through-hole 280 and a plurality of internal conducting coatings 214 and 224. The internal conducting coatings 214 and 224 connected to a wall 288 of the through-hole 280 are physically and electrically insulated. However, each of the internal conducting coatings 214 and 224 are electrically connected with corresponding upper pads 210 and 220 and lower pads 212 and 222 so that electrical connection between layers can be done.

In a preferred embodiment, the via is formed with a plated through-hole (PTH), which is obtained by mechanical or laser drilling through an insulation layer of a substrate and then electroplating the wall of the through-hole with a conductive material such as copper. By the internal conducting coating and pads on both sides of the insulation layer, a first surface 202a and a second surface 202b, electrical connection between layers is accomplished. The pads are formed in the step of patterning a conduction layer above the insulation layer.

A core layer in a multi-layer circuit board is shown in the figures. The core layer, such as made by a copper clad laminate (CCL), includes an insulation layer 202 and two conduction layers respectively bonded to a top side, the first surface 202a, and bottom side, the second surface 202b, of the insulation layer 202. In the embodiment, the conduction layer is a copper clad. It should be noted that only the pads 210, 220, 212 and 222 of the conduction layer are shown in the figures.

A first internal conducting coating 214 and a second internal conducting coating 224 connected with a wall 288 are separated from each other, with an internal hole gap 282 between two internal conducting coatings. Therefore, electrical isolation between two coatings is available and each internal conducting coating is responsible for individual signal transmission. Pad gaps 284 and 286 electrically isolate a first upper pad 210 and a second upper pad 220 and a first lower pad 212 and a second lower pad 222, respectively. Also, each of the pads is electrically connected to a corresponding internal conducting coating.

In electrical signal transmission from the top side to the bottom side of the insulation layer 202, for example, a first signal goes through the first upper pad 210, the first internal conducting coating 214 and the lower pad 212. Analogously, a second signal is transmitted through the second upper 220, the second internal conducting coating 224 and the second lower pad 222, which is independent of the first signal transmission above.

The isolation between the internal conducting coatings 214 and 224 can also be achieved by an insulating material; any means may be used as long as electrical separation is obtained. Gaps are used for electrical isolation of the internal conducting coatings and that of the pads. For example, the internal hole gap may either be at the same position as the wall, as shown in the Fig. 2B, or in the form of the structure extending from the wall such as the internal hole gap 282a shown in Fig. 2C.

The internal conducting coating can be made of a metallic material such as gold, silver, copper, iron, aluminum or an alloy thereof, and is formed on the wall of the through-hole by way of electroplating or other deposition method.

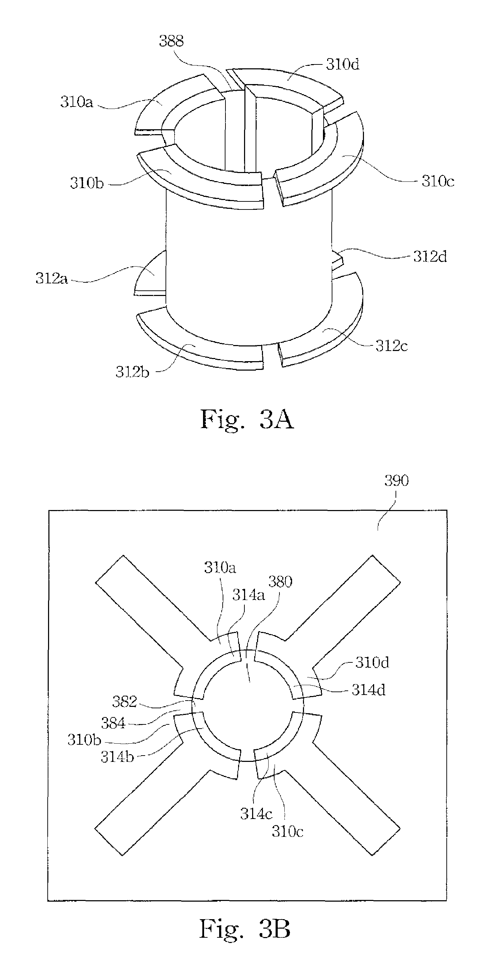

The present invention can further extend to a multiple (more than two) signal version. Reference is now made to Figs. 3A and 3B. Fig. 3A is a schematic view of a via structure of a printed circuit board in accordance with another preferred embodiment of the present invention; Fig. 3B is a top view of the via structure of the printed circuit board in Fig. 3A.

In another preferred embodiment, the present invention presents a via capable of transmitting four signals. A through-hole 380 is divided into four conductive areas which are responsible for transmitting four electrical signals. Pad gaps 384 are used for separation between upper pads 310a ~ 310d, as well as for lower pads 312a - 312d. Internal conducting coatings 314a ~ 314d connected to a wall 388 are also isolated physically and electrically from each other by internal hole gaps 382.

Each of four electrical signal transmissions between layers is through corresponding upper pads, internal conducting coatings and lower pads.

The present invention has the following advantage. With a plurality of separate conductive paths formed by dividing a single through-hole into several segments, each responsible for a specific signal, simultaneous multiple signal transmissions between layers by one via are achieved. Hence, the number of vias required for a complicated circuit layout is reduced and the cost of the circuit board is also lowered due to it consuming less space.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A via structure of a printed circuit board, comprising:
an insulation layer having a first surface and a second surface;
a through-hole disposed in the insulation layer having openings at the first surface and the second surface; and
a plurality of internal conducting coatings connected to a wall of the through-hole,
wherein the internal conducting coatings are isolated and electrically insulated from each other.

2. The via structure of claim 1, wherein the through-hole comprises a plurality of internal hole gaps for isolating the internal conducting coatings from each other.

3. The via structure of claim 1, wherein the internal conducting coatings are insulated from each other by an insulating material.

4. The via structure of claim 1, wherein the internal conducting coatings are made of a material selected from a group consisting of Au, Ag, Cu, Fe and Al.

5. A printed circuit board, comprising:
an insulation layer having a first surface and a second surface;
a through-hole disposed in the insulation layer having openings at the first surface and the second surface and having a plurality of internal hole gaps;
a plurality of internal conducting coatings connected to a wall of the through-hole, wherein the internal conducting coatings are isolated and electrically insulated from each other by the internal hole gaps; and
a conductive layer connected to the insulation layer and having a plurality of pads, wherein the pads are correspondingly electrically connected to the internal conducting coatings and are isolated physically and insulated electrically from each other.

6. The printed circuit board of claim 5, wherein the conduction layer and the insulation layer comprise a copper clad laminate (CCL).

7. A printed circuit board, comprising:
a through-hole;
a plurality of internal conducting coatings connected to a wall of the through-hole, wherein the internal conducting coatings are isolated and electrically insulated from each other;
a plurality of upper pads connected to a side of the internal conducting coating; and
a plurality of lower pads connected to another side of the internal conducting coating.

8. The printed circuit board of claim 7, wherein the through-hole comprises a plurality of internal hole gaps for isolating the internal conducting coatings from each other.

9. The printed circuit board of claim 7, wherein the internal conducting coatings are insulated from each other by an insulating material.

10. The printed circuit board of claim 7, wherein the through-hole is disposed in an insulation layer.
